# EUROPEAN PATENT APPLICATION

(11) **EP 2 334 150 A1**
(43) Date of publication of application: **15.06.2011**
(21) Application number: 09813028.9
(22) Date of filing: 02.09.2009
(51) Int. Cl.: H05B 33/10, H01L 51/50

(54) **INK FOR MANUFACTURING ORGANIC ELECTROLUMINESCENT ELEMENT, METHOD FOR MANUFACTURING ORGANIC ELECTROLUMINESCENT ELEMENT, AND DISPLAY DEVICE**

(30) Priority: 12.09.2008 JP 2008234471
(71) Applicant: Sumitomo Chemical Company, Limited, Tokyo 104-8260 (JP)
(72) Inventor: ROKUHARA, Kouichi, Shimotsuma-shi Ibaraki 304-0823 (JP)
(74) Representative: Duckworth, Timothy John
(86) International application number: PCT/JP2009/065353
(87) International publication number: WO 2010/029882

(57) **Abstract**

An ink used for forming an organic layer of an organic electroluminescent element comprising a pair of electrodes and the organic layer interposed between the electrodes by a printing method. The ink comprises a first solvent having a boiling point of equal to or more than 220°C and a constituent material of the organic layer and has a surface tension of less than 34 mN/m.

## Description

### TECHNICAL FIELD

The present invention relates to an ink used for forming an organic layer of an organic electroluminescent element (hereinafter, also referred to as an "organic EL element") by a printing method, a method for manufacturing an organic EL element using the ink, and a display device.

### BACKGROUND ART

An organic EL element comprises a pair of electrodes and an organic layer that is interposed between the pair of electrodes and that comprises at least one light-emitting layer. The organic EL element emits light by recombining holes and electrons that are injected from the pair of electrodes in the light-emitting layer.

The formation of the organic layer of such an organic EL element by a coating method with a simple process has been studied. For example, studied is the formation of the organic layer by applying an ink comprising a material constituting the organic layer and a solvent by a coating method such as an ink-jet printing method, a spin coating method, and a letterpress printing method and by drying the ink.

In the letterpress printing method, an ink is applied in a pattern by making the ink adhere to a letterpress in which a predetermined convex portion is formed in the pattern and by transferring the adhering ink to an object to be printed such as a substrate. The film thickness of the organic layer is small, generally 1 micrometer or less, and thus, the ink made to adhere to the letterpress is also applied thinly according to the film thickness of the organic layer. When such an ink having a small film thickness is made to adhere to a letterpress, the ink dries while adhering to the letterpress before the ink is transferred to an object to be printed, which increases the viscosity of the ink. Therefore, release properties of the ink from the letterpress may deteriorate, and as a result, the ink may not be transferred to the object to be printed. For solving this problem, the conventional art employs an ink comprising at least one type of solvent that has a vapor pressure of 500 Pa (Pascals) or less and that is hard to dry. The use of such an ink comprising a solvent hard to dry can prevent the ink from drying while adhering to a letterpress and improve the release properties of the ink from the letterpress. Thus, the conventional art enables an ink adhering to a letterpress to be transferred to an object to be printed (see Patent Document 1, for example).

### Patent Document

Patent Document 1: JP 2001-155861 A

### DISCLOSURE OF INVENTION

### PROBLEM TO BE SOLVED BY THE INVENTION

Uneven distribution in the film thickness of an organic layer such as a light-emitting layer causes uneven light emission, electric field concentration, and the like, and therefore, uniformity is required for the film thickness of the organic layer. The conventional art employs a solvent hard to dry to enable an ink adhering to a letterpress to be transferred. However, because the solvent is hard to dry, when the ink is transferred onto an object to be printed, the ink comprises a comparatively large amount of remaining solvent and maintains its viscosity in a relatively low state. The shape of the ink transferred onto the object to be printed is deformed by its surface tension in a direction where the surface area of the ink decreases. Particularly in the conventional art, an ink is transferred onto an object to be printed while maintaining its viscosity in a relatively low state. Therefore, after the ink is transferred, its shape is deformed by its surface tension to have a dome-shaped cross section. The ink is dried while maintaining this shape to form an organic layer with a dome-shaped cross section. Therefore, it is difficult to form an organic layer having a uniform film thickness by the conventional art.

Accordingly, an object of the present invention is to provide an ink for manufacturing an organic EL element that allows the formation of an organic layer having a uniform film thickness.

### MEANS FOR SOLVING PROBLEM

The present invention provides the following:
[1] An ink for forming an organic layer of an organic electroluminescent element by a printing method, the ink comprising:
   a first solvent having a boiling point of equal to or higher than 220°C; and
   a constituent material of the organic layer, wherein the ink has a surface tension of less than 34 mN/m.
[2] The ink according to above [1], wherein the amount of the first solvent per 100 parts by weight of the ink is equal to or more than 5 parts by weight and less than 40 parts by weight.
[3] The ink according to above [1] or [2], further comprising a second solvent having a boiling point of equal to or higher than 150°C and lower than 220°C.
[4] The ink according to above [3], wherein the amount of the second solvent per 100 parts by weight of the ink is equal to or more than 20 parts by weight and less than 70 parts by weight.
[5] The ink according to any one of above [1] to [4], further comprising a third solvent having a boiling point of lower than 150°C.
[6] The ink according to above [3], further comprising a third solvent having a boiling point of lower than 150°C.
[7] The ink according to above [5], wherein the amount of the third solvent per 100 parts by weight of the ink is equal to or more than 20 parts by weight and less than 70 parts by weight.
[8] A method for manufacturing an organic electroluminescent element comprising:
   preparing an ink that comprises a first solvent having a boiling point of equal to or higher than 220°C and an organic material and that has a surface tension of less than 34 mN/m; and
   forming an organic layer by applying the ink by a printing method.
[9] The method for manufacturing an organic electroluminescent element according to above [8], wherein the amount of the first solvent per 100 parts by weight of the ink is equal to or more than 5 parts by weight and less than 40 parts by weight.
[10] The method for manufacturing an organic electroluminescent element according to above [8], wherein the ink further comprises a second solvent having a boiling point of equal to or higher than 150°C and lower than 220°C.
[11] The method for manufacturing an organic electroluminescent element according to above [10], wherein the amount of the second solvent per 100 parts by weight of the ink is equal to or more than 20 parts by weight and less than 70 parts by weight.
[12] The method for manufacturing an organic electroluminescent element according to above [8], wherein the ink further comprises a third solvent having a boiling point of lower than 150°C.
[13] The method for manufacturing an organic electroluminescent element according to above [12], wherein the amount of the third solvent per 100 parts by weight of the ink is 20 equal to or more than parts by weight and less than 70 parts by weight.
[14] A display device comprising an organic electroluminescent element manufactured by the method for manufacturing an organic electroluminescent element according to above [8].

### EFFECT OF THE INVENTION

According to the present invention, an organic layer having a uniform film thickness can be formed by a printing method using an ink that comprises a first solvent having a boiling point of equal to or higher than 220°C and a constituent material of the organic layer and that has a surface tension of less than 34 mN/m.

### BRIEF DESCRIPTION OF DRAWINGS

FIG. 1 is a graph indicating the cross-sectional shape of an organic layer of Example 1.
FIG. 2 is a graph indicating the cross-sectional shape of an organic layer of Example 2.
FIG. 3 is a graph indicating the cross-sectional shape of an organic layer of Example 3.

### BEST MODE(S) FOR CARRYING OUT THE INVENTION

An ink of the present embodiment is used for forming an organic layer of an organic electroluminescent element comprising a pair of electrodes and the organic layer interposed between the electrodes by a printing method. The ink of the present embodiment comprises a first solvent having a boiling point of equal to or higher than 220 °C and a constituent material of the organic layer. Moreover, the ink of the present embodiment is characterized in that the surface tension of the ink is less than 34 mN/m.

Examples of the printing method comprise a letterpress printing method, an intaglio printing method, a gravure printing method, a planographic printing method, and an offset printing method. Among them, a letterpress printing method is preferred, and a flexographic printing method is more preferred.

Although a method for forming an organic layer by a flexographic printing method is described below, an organic layer having a uniform film thickness can also be formed even when the organic layer is formed by the other printing methods using the ink of the present embodiment. In a flexographic printing method, an ink is made to adhere to the convex portion of a letterpress winded around an impression cylinder, and the letterpress is pressed against an object to be printed while rotating with the impression cylinder. In such a manner, a flexographic printing method can transfer an ink patterned according to the pattern of the letterpress onto the object to be printed.

The letterpress is preferably a flexographic printing plate made of elastic materials such as resins, and examples of the elastic materials include polyester resins.

Examples of the method of making an ink adhere to the letterpress include a method of making an ink adhere to the convex portion of the letterpress by forming a thin film of the ink on the surface of a roller in advance and by making the letterpress abut the roller. For example, a thin film of the ink can be formed on the surface of a roller by dipping the roller while rotating into the ink contained in a tank for storing liquid. The ink having a desired film thickness can also be formed on the surface of the roller by removing redundant ink using a blade or the like. In such a manner, a thin film of the ink is formed on the surface of the roller in advance, and then, both the roller and the letterpress are rotated while being abutted to each other. Thus, the thin film of the ink formed on the surface of the roller can be made to adhere to the convex portion of the letterpress selectively.

The ink used in the present embodiment comprises the first solvent that has a boiling point of equal to or higher than 220°C and is comparatively hard to dry, and thus can be prevented from drying before the ink is transferred onto the object to be printed. Accordingly, when the ink is transferred from the letterpress onto the object to be printed, the ink comprises a comparatively large amount of remaining solvent and maintains its viscosity in a relatively low state. Surface tension occurs in the ink transferred onto the object to be printed in a direction where the surface area of the ink decreases. However, the ink of the present embodiment has a small surface tension of less than 34 mN/m. Therefore, the cross-sectional shape of the ink is not deformed to be a dome shape because the viscosity that inhibits the deformation due to the surface tension is moderately balanced with the surface tension. While the projections and depressions on the surface of the ink that are formed when the ink is transferred are smoothed to deform the surface to the extent of being flat, the ink is dried while maintaining its cross-sectional shape at the time of the transfer in an approximately rectangular shape. Consequently, an organic layer whose surface is flat, whose cross-sectional shape is a approximately rectangular shape, and that has a uniform film thickness can be formed.

Examples of the first solvent having a boiling point of equal to or higher than 220°C include cyclohexylbenzene (CHB).

When the amount of the first solvent relative to the ink is too small, the solvent of the ink evaporates in a state of adhering to the letterpress to increase the viscosity of the ink. Therefore, the projections and depressions formed on the surface of the ink at the time of the transfer may not be smoothed even by the surface tension, and the surface of the organic layer may be formed in an uneven shape. When the amount of the first solvent relative to the ink is too large, the amount of the solvent remaining in the ink when the ink is transferred from the letterpress onto the object to be printed becomes high to decrease the viscosity. Therefore, the cross-sectional shape may easily be in a dome shape by the surface tension. Seen from this standpoint, the amount of the first solvent per 100 parts by weight of the ink is preferably, equal to or more than 5 parts by weight and less than 40 parts by weight, and more preferably, equal to or more than 5 parts by weight and less than 20 parts by weight. In the present specification, "per 100 parts by weight of the ink" means "per 100 parts by weight of the ink contained in a tank". The surface tension of the ink varies during a printing process because the solvent dries to change the ingredient of the ink. The surface tension of the ink in the present specification means a surface tension of the ink at the time when the ink is supplied to the tank.

The surface tension of the ink is preferably 25 mN/m or more. The ink transferred onto the object to be printed can maintain its shape at the time of the transfer, and the projections and depressions on the surface of the ink at the time of the transfer can be smoothed, by having such a moderate surface tension.

The solvent of the ink may comprise the first solvent described above alone, but preferably further comprises a second solvent having a boiling point of equal to or higher than 150°C and lower than 220°C. In other words, the ink preferably comprises the second solvent that exhibits a quick-drying property as compared with the first solvent. Thus, the ink transferred onto the object to be printed can maintain its cross-sectional shape in an approximately rectangular shape by comprising the second solvent that exhibits a quick-drying property as compared with the first solvent. This is because, the second solvent is moderately dried when the ink is transferred onto the object to be printed, and the viscosity of the ink is in a moderately high state. Accordingly, an organic layer whose surface is flat, whose cross-sectional shape is a approximately rectangular shape, and that has a uniform film thickness can be formed by using such an ink.

Examples of the second solvent having a boiling point of equal to or higher than 150°C and lower than 200°C include cyclohexanone, tetralin, and anisole.

The amount of the second solvent per 100 parts by weight of the ink is preferably equal to or more than 20 parts by weight and less than 50 parts by weight. An organic layer whose surface is flat, whose cross-sectional shape is an approximately rectangular shape, and that has a uniform film thickness can be formed by mixing the second solvent in such the amount.

The ink preferably further comprises a third solvent having a boiling point of lower than 150°C. In other words, the ink preferably comprises the third solvent that exhibits a quick-drying property as compared with the first solvent and the second solvent. The ink comprising the first solvent and the third solvent or the ink comprising the first solvent, the second solvent, and the third solvent is preferred. Thus, the ink is easily selectively supplied to the convex portion of the letterpress by comprising the third solvent that exhibits a quick-drying property. This is because, when the ink is made to adhere from the roller to the letterpress, the third solvent is adequately dried to increase the viscosity of the ink moderately. Therefore, the ink is easily kept on the letterpress when the letterpress abuts the roller.

Examples of the third solvent having a boiling point of lower than 150°C include toluene, chloroform, and xylene.

The amount of the third solvent per 100 parts by weight of the ink is preferably equal to or more than 50 parts by weight and less than 70 parts by weight. The ink becomes easily selectively supplied to the convex portion of the letterpress by mixing the third solvent in such the amount.

The amount of the constituent material of the organic layer per 100 parts by weight of the ink is generally, equal to or more than 0.1 part by weight and less than 5 parts by weight, preferably, equal to or more than 0.5 part by weight and less than 3 parts by weight, and more preferably, equal to or more than 1 part by weight and less than 2 parts by weight.

For preparing the ink having a surface tension of less than 34 mN/m, a solvent having a small surface tension may be selectively used, and specifically, a solvent having a small surface tension may be selectively used for the solvent whose content in the ink is large. The surface tension of the ink may be measured by a plate method.

The structure of an organic EL element and a method for manufacturing an organic EL element using the ink described above are described below.

An organic EL element comprises a pair of electrodes and an organic layer that is interposed between the pair of electrodes and that comprises at least one light-emitting layer. Generally, the organic EL element is formed on a substrate. For example, in an active matrix type display device, a plurality of organic EL elements is formed on a thin film transistor (TFT) substrate, and in a passive matrix type display device, a plurality of organic EL elements is formed on a substrate on which predetermined wiring and the like is formed. The organic EL element is manufactured by separately forming a pair of electrodes and an organic layer interposed between the electrodes. Specifically, the organic EL element is manufactured by stacking the components of the organic EL element on the substrate in sequence.

The organic EL element comprises at least a light-emitting layer between an anode and a cathode that serve as electrodes, and may further comprise a layer different from the light-emitting layer. Examples of the layer provided between the cathode and the light-emitting layer comprise an electron injection layer, an electron transport layer, and a hole block layer and the like.
When both of the electron injection layer and the electron transport layer are provided between the cathode and the light-emitting layer, a layer making contact with the cathode is called the electron injection layer, and the layer except for the electron injection layer is called the electron transport layer.

The electron injection layer is a layer having function to improve electron injection efficiency from the cathode. The electron transport layer is a layer having function to improve electron injection from the cathode, the electron injection layer, or the electron transport layer closer to the cathode. The hole block layer is a layer having function to block the transport of holes. When any one of the electron injection layer and the electron transport layer or both has function to block the transport of holes, the layer may also serve as the hole block layer.

The function of the hole block layer to block the transport of holes can be confirmed by, for example, manufacturing an element in which only hole current flows and confirming an effect of blocking holes through the reduction of the current value.

Examples of the layer provided between the anode and the light-emitting layer include a hole injection layer, a hole transport layer, and an electron block layer. When both of the hole injection layer and the hole transport layer are provided between the anode and the light-emitting layer, a layer making contact with the anode is called the hole injection layer, and the layer except for the hole injection layer is called the hole transport layer.

The hole injection layer is a layer having function to improve hole injection efficiency from the anode. The hole transport layer is a layer having function to improve hole injection from the anode, the hole injection layer, or the hole transport layer closer to the anode. The electron block layer is a layer having function to block the transport of electrons. When any one of the hole injection layer and the hole transport layer or both has function to block the transport of electrons, the layer may also serve as the electron block layer.

The function of the electron block layer to block the transport of electrons can be confirmed by, for example, manufacturing an element in which only electron current flows and confirming an effect of blocking electrons through the reduction of the current value.

The electron injection layer and the hole injection layer may be collectively called charge injection layers, and the electron transport layer and the hole transport layer may be collectively called charge transport layers.

The examples of layer structures applicable to the organic EL element of the present embodiment are described below.
a) anode/light-emitting layer/cathode
b) anode/hole injection layer/light-emitting layer/cathode
c) anode/hole injection layer/light-emitting layer/electron injection layer/cathode
d) anode/hole injection layer/light-emitting layer/electron transport layer/cathode
e) anode/hole injection layer/light-emitting layer/electron transport layer/electron injection layer/cathode
f) anode/hole transport layer/light-emitting layer/cathode
g) anode/hole transport layer/light-emitting layer/electron injection layer/cathode
h) anode/hole transport layer/light-emitting layer/electron transport layer/cathode
i) anode/hole transport layer/light-emitting layer/electron transport layer/electron injection layer/cathode
j) anode/hole injection layer/hole transport layer/light-emitting layer/cathode
k) anode/hole injection layer/hole transport layer/light-emitting layer/electron injection layer/cathode
l) anode/hole injection layer/hole transport layer/light-emitting layer/electron transport layer/cathode
m) anode/hole injection layer/hole transport layer/light-emitting layer/electron transport layer/electron injection layer/cathode
n) anode/light-emitting layer/electron injection layer/cathode
o) anode/light-emitting layer/electron transport layer/cathode
p) anode/light-emitting layer/electron transport layer/electron injection layer/cathode
   (Where a symbol "forward slash (/)" indicates that the layers crossing the symbol "/" are adjacently stacked. The same shall apply hereinafter.)
   The organic EL element of the present embodiment may comprise two or more light-emitting layers. Examples of the organic EL element having two light-emitting layers include a layer structure of q) below where a layered body interposed between an anode and a cathode among any one of the layer structures of a) to p) described above is indicated by a "repeating unit A".
q) anode/(repeating unit A)/charge generation layer/(repeating unit A)/cathode
   Examples of the organic EL element having three or more light-emitting layers include a layer structure of r) below where "(repeating unit A)/charge generation layer" is indicated by a "repeating unit B".
r) anode/(repeating unit B)x/(repeating unit A)/cathode
In this structure, a symbol "x" is an integer of two or more, and (repeating unit B)x is a layered body in which the repeating unit B is layered x times.

The charge generation layer is a layer generating holes and electrons when electric field is applied thereto. Examples of the charge generation layer include a thin film made of vanadium oxide, indium tin oxide (ITO), molybdenum oxide, or other compounds.

The organic EL element may be provided on a substrate or may be covered by a sealing member such as a sealing film or a sealing plate for sealing. When the organic EL element is provided to the substrate, generally, the anode is arranged near the substrate, but the cathode may also be arranged near the substrate.

In the organic EL element of the present embodiment, all of the layers arranged at the side from which light is extracted relative to the light-emitting layer are translucent in order to extract light from the light-emitting layer to the exterior. Depending on the design, the organic EL element may be a bottom emission type organic EL element in which light is extracted from the substrate or may be a top emission type organic EL element in which light is extracted from the side opposite to the substrate.

### (Substrate)

A substrate that is not deformed while the organic El element is manufactured is suitably used for the substrate. For example, glass, plastic, polymer films, silicon substrates, and layered bodies thereof are used. For the substrate, a commercial substrate is available, or the substrate can be manufactured by a publicly known method.

### (Anode)

The organic EL element with a structure in which light is extracted from the light-emitting layer through the anode employs a transparent or semitransparent electrode for the anode. A thin film of metallic oxides, metallic sulphides, metals, or the like that have high electric conductivity is applicable to the transparent electrode or the semitransparent electrode, and an anode with high light transparency is suitably used. Specifically, a thin film made of, for example, indium oxide, zinc oxide, tin oxide, ITO, indium zinc oxide (IZO), gold, platinum, silver, and copper is used, and among them, a thin film made of ITO, IZO, and tin oxide is suitably used. A transparent conductive film of organic substances such as polyaniline or derivatives thereof and polythiophene or derivatives thereof may also be used for the anode.

A material that reflects light may also be used for the anode. For the material, metals, metallic oxides, and metallic sulphides, all of which have a work function of 3.0 electron volts or more are preferred.

The film thickness of the anode can be appropriately selected in consideration of light transparency and electric conductivity and is, for example, 10 nanometers to 10 micrometers, preferably, 20 nanometers to 1 micrometer, and more preferably, 50 nanometers to 500 nanometers.

### (Hole injection layer)

Examples of the constituent material of the hole injection layer include: oxides such as vanadium oxide, molybdenum oxide, ruthenium oxide, and aluminum oxide; and organic substances such as phenylamines, starburst-type amines, phthalocyanines, amorphous carbon, polyaniline, and polythiophene derivatives.

The optimal value for the film thickness of the hole injection layer varies depending on the material used. The film thickness is selected as appropriate so as to have moderate values of driving voltage and light-emitting efficiency and needs to be at least a thickness with which no pinhole is formed. When the thickness is too large, the driving voltage of the element may increase. Accordingly, the film thickness of the hole injection layer is, for example, 1 nanometer to 1 micrometer, preferably, 2 nanometers to 500 nanometers, and more preferably, 5 nanometers to 200 nanometers.

### (Hole transport layer)

Examples of the constituent material of the hole transport layer include organic substances such as polyvinyl carbazole or derivatives thereof, polysilane or derivatives thereof, polysiloxane derivatives having an aromatic amine at the side chain or the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, or poly(2,5-thienylene vinylene) or derivatives thereof.

Among them, examples of the hole transport material include: preferably, a polymer hole transport material such as polyvinyl carbazole or derivatives thereof, polysilane or derivatives thereof, polysiloxane derivatives having an aromatic amine compound group at the side chain or the main chain, polyaniline or derivatives thereof, polythiophene or derivatives thereof, polyarylamine or derivatives thereof, poly(p-phenylenevinylene) or derivatives thereof, or poly(2,5-thienylene vinylene) or derivatives thereof; and more preferably, polyvinyl carbazole or derivatives thereof, polysilane or derivatives thereof, and polysiloxane derivatives having an aromatic amine at the side chain or the main chain. When the hole transport material is a low molecular material, the material is preferably used by being dispersed in a macromolecular binder.

The optimal value for the film thickness of the hole transport layer varies depending on the material used. The film thickness is selected as appropriate so as to have moderate values of driving voltage and light-emitting efficiency and needs to be at least a thickness with which no pinhole is formed. When the thickness is too large, the driving voltage of the element may increase. Accordingly, the film thickness of the hole transport layer is, for example, 1 nanometer to 1 micrometer, preferably, 2 nanometers to 500 nanometers, and more preferably, 5 nanometers to 200 nanometers.

### (Light-emitting layer)

The light-emitting layer is generally made of an organic substance that mainly emits any one of fluorescence and phosphorescence or both, or made of the organic substance and a dopant assisting the organic substance. The dopant is added in order to, for example, improve light-emitting efficiency and change a light-emitting wavelength. The organic substance may be a low molecular compound or a macromolecular compound. The light-emitting layer preferably comprises a macromolecular compound having a number average molecular weight of 10³ to 10⁸ in terms of polystyrene. Examples of the constituent material of the light-emitting layer include the following pigment materials, metal complex materials, macromolecular materials, and dopant materials.

### (Pigment materials)

Examples of the pigment materials include cyclopendamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perynone derivatives, perylene derivatives, oligothiophene derivatives, oxadiazole dimmers, pyrazoline dimmers, quinacridone derivatives, and coumarin derivatives.

### (Metal complex materials)

Examples of the metal complex materials include metal complexes having as a central metal, A1, Zn, Be, a rare-earth metal such as Tb, Eu, and Dy, or the like and having as a ligand, a structure of oxadiazole, thiadiazole, phenylpyridine, phenylbenzimidazole, quinoline, or the like, for example, metal complexes such as iridium complexes and platinum complexes that emit light from the triplet excited state, alumiquinolinol complexes, benzoquinolinole beryllium complexes, benzoxazolyl zinc complexes, benzothiazole zinc complexes, azomethyl zinc complexes, porphyrin zinc complexes, and europium complexes.

### (Macromolecular materials)

Examples of the polymer materials include polyparaphenylene vinylene derivatives, polythiophene derivatives, polyparaphenylene derivatives, polysilane derivatives, polyacetylene derivatives, polyfluorene derivatives, polyvinyl carbazole derivatives, and materials obtained by polymerizing the pigment materials or the metal complex light-emitting materials.

Among the light-emitting materials described above, examples of the material that emits blue light include distyrylarylene derivatives, oxadiazole derivatives, and polymers of the distyrylarylene derivatives and the oxadiazole derivatives, polyvinyl carbazole derivatives, polyparaphenylene derivatives, and polyfluorene derivatives. Among them, polymer materials such as polyvinyl carbazole derivatives, polyparaphenylene derivatives, and polyfluorene derivatives are preferred.

Examples of the material that emits green light include quinacridone derivatives, coumarin derivatives, polymers of the quinacridone derivatives and the coumarin derivatives, polyparaphenylene vinylene derivatives, and polyfluorene derivatives. Among them, polymer materials such as polyparaphenylene vinylene derivatives and polyfluorene derivatives are preferred.

Examples of the material that emits red light include coumarin derivatives, thiophene ring compounds, polymers of the coumarin derivatives and the thiophene ring compounds, polyparaphenylene vinylene derivatives, polythiophene derivatives, and polyfluorene derivatives. Among them, polymer materials such as polyparaphenylene vinylene derivatives, polythiophene derivatives, and polyfluorene derivatives are preferred.

### (Dopant materials)

Examples of the dopant materials include perylene derivatives, coumarin derivatives, rubrene derivatives, quinacridone derivatives, squarylium derivatives, porphyrin derivatives, styryl pigments, tetracene derivatives, pyrazolone derivatives, decacyclene, and phenoxazon. The thickness of such a light-emitting layer is generally about 2 nanometers to 200 nanometers.

### (Electron transport layer)

As an electron transport material that constitutes the electron transport layer, a publicly known material can be used. Examples of the material include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives of 8-hydroxyquinoline, polyquinoline or derivatives thereof, polyquinoxaline or derivatives thereof, and polyfluorene or derivatives thereof.

Among them, oxadiazole derivatives, benzoquinone or derivatives thereof, anthraquinone or derivatives thereof, metal complexes of 8-hydroxyquinoline or of derivatives of 8-hydroxyquinoline, polyquinoline or derivatives thereof, polyquinoxaline or derivatives thereof, and polyfluorene or derivatives thereof are preferred, and 2-(4-biphenylyl)-5-(4-t-butylphenyl)-1,3,4-oxadiazole, benzoquinone, anthraquinone, tris(8-quinolinol)aluminum, and polyquinoline are more preferred as the electron transport material.

The optimal value for the film thickness of the electron transport layer varies depending on the material used. The film thickness is selected as appropriate so as to have moderate values of driving voltage and light-emitting efficiency and needs to be at least a thickness with which no pinhole is formed. When the thickness is too large, the driving voltage of the element may increase. Accordingly, the film thickness of the electron transport layer is, for example, 1 nanometer to 1 micrometer, preferably, 2 nanometers to 500 nanometers, and more preferably, 5 nanometers to 200 nanometers.

### (Electron injection layer)

For the constituent material of the electron injection layer, an optimal material is appropriately selected depending on the type of the light-emitting layer. Examples of the constituent material include: alkali metals; alkaline-earth metals; alloys that contain one or more types of alkali metals and alkaline-earth metals; oxides, halides, and carbonates of alkali metals or alkaline-earth metals; or a mixture of these substances. Examples of the alkali metals, or the oxides, halides, and carbonates of the alkali metals include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals or the oxides, halides, and carbonates of the alkaline-earth metals include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may also be a layered body in which two or more layers are stacked, examples thereof include LiF/Ca. The film thickness of the electron injection layer is preferably about 1 nanometer to 1 micrometer.

### (Cathode)

A material that has a small work function, facilitates electron injection into the light-emitting layer, and has high electric conductivity is preferred as a material for the cathode. In the organic EL element in which light is extracted from the anode, a material having high reflectance of visible light is preferred as the material for the cathode because the cathode reflects the light output from the light-emitting layer to the anode. For example, alkali metals, alkaline-earth metals, transition metals, and the 13th-group metals in the periodic table can be used for the cathode. Examples of the material for the cathode include: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more types of the metals; alloys of one or more types of the metals and one or more types of gold, silver, platinum, copper, manganese, titanium, cobalt, nickel, tungsten, and tin; or graphite or graphite interlayer compounds. Examples of the alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. For the cathode, a transparent conductive electrode made of a conductive metal oxide, a conductive organic substance, or the like can be used. Specific examples of the conductive metal oxide include indium oxide, zinc oxide, tin oxide, ITO, and IZO. Specific examples of the conductive organic substance include polyaniline or derivatives thereof and polythiophene or derivatives thereof. The cathode may be a layered body in which two or more layers are stacked. The electron injection layer may also be used as the cathode.

The film thickness of the cathode is appropriately set in consideration of electric conductivity and durability and is, for example, 10 nanometers to 10 micrometers, preferably, 20 nanometers to 1 micrometer, and more preferably, 50 nanometers to 500 nanometers.

### (Method for Manufacturing the organic EL element)

The organic EL element can be formed by stacking the components of the organic EL element described above in sequence.

Examples of the method for manufacturing the anode include a vacuum deposition method, a sputtering method, an ion plating method, and a plating method.

Among the layers interposed between the anode and the cathode, the organic layers comprising organic substances can be formed by a printing method using the ink comprising the constituent material of the organic layer described above in the present embodiment. At least one of the organic layers is formed by a printing method using the ink comprising the constituent material of the organic layer described above in the present embodiment. For example, the layers comprising organic substances out of the hole injection layer, the hole transport layer, the light-emitting layer, the electron transport layer, the electron injection layer, and other layers correspond to the organic layers. At least one of the organic layers is formed by a printing method using the ink comprising the constituent material of the organic layer described above in the present embodiment. The constituent material of the organic layer is a material that turns into an organic layer after the ink becomes a film. For example, when the organic layer is formed through cross-linking, a material before the cross-linking corresponds to the constituent material of the organic layer.

The constituent material of the organic layer comprises any one of a low molecular compound and a macromolecular compound or both and is preferably a macromolecular compound in terms of solubility. The macromolecular compound preferably has a number average molecular weight of 10³ to 10⁶ in terms of polystyrene.

Among the layers interposed between the anode and the cathode, the organic layers comprising organic substances are preferably formed by the printing method using the ink as described above when the constituent material of each of the organic layers described above are soluble in a solvent. However, an organic layer that cannot be formed by a printing method, an organic layer that can be formed into a film by a simpler method than a printing method, an inorganic layer, and other layers may be formed by a method other than a printing method and can be formed by, for example, a vapor deposition method and a sputtering method.

At least one of the organic layers that are interposed between the anode and the cathode and that comprise organic substances is formed by the printing method using the ink described above. However, the other organic layers may be formed by a coating method such as a spin coating method, a casting method, a micro-gravure coating method, a gravure coating method, a bar coating method, a roll coating method, a wire bar coating method, a dip coating method, a spray coating method, and an ink-jet printing method.

Examples of a method for manufacturing the cathode include a vacuum deposition method, a sputtering method, a lamination method by which a metal thin film is thermocompression bonded.

For example, a color display device requires three types of organic EL elements selectively formed by applying light-emitting materials that emit light in three colors (red, green, and blue) selectively. In such a device, light-emitting layers that emit light in three different colors are formed by color in sequence by a printing method using three types of more than one such ink of the present embodiment that comprise light-emitting materials emitting light in the colors. Thus, three types of organic EL elements can be selectively formed.

The organic EL element as described above can be suitably used for a curved or flat illumination device, a planar light source used for, for example, a light source of a scanner, and a display device.

Examples of the display device including the organic EL element include a segment display device and a dot-matrix display device. Examples of the dot-matrix display device include an active matrix display device and a passive matrix display device. In the active matrix display device and the passive matrix display device, the organic EL element is used as a light-emitting element constituting each pixel. The organic EL element is used as a light-emitting element constituting each segment in the segment display device and is used as a backlight in a liquid crystal display device.

### (Examples)

The present invention is described in detail with reference to Examples below but is not limited thereto.

Three types of inks (a first ink, a second ink, and a third ink) were prepared, and the first ink, the second ink, and the third ink were individually printed on a glass substrate in patterns by a flexographic printer. Each of the inks was prepared so as to comprise 1.5% by mass of a polymer light-emitting material (Lumation GP1300, manufactured by Sumation Co Ltd). Table 1 indicates the amount of solvents (a first solvent, a second solvent, and a third solvent) comprised in each ink and the surface tension of the ink.

(Table. 1)

**Table. 1**

| | FIRST SOLVENT CHB (PARTS BY WEIGHT) | SECOND SOLVENT ANISOLE (PARTS BY WEIGHT) | THIRD SOLVENT XYLENE (PARTS BY WEIGHT) | SURFACE TENSION (34 mN/m) |
|---|---|---|---|---|
| EXAMPLE 1 (FIRST INK) | 10 | 30 | 60 | 31.5 |
| EXAMPLE 2 (SECOND INK) | 10 | 60 | 30 | 32.5 |
| COMPARATIVE EXAMPLE 1 (THIRD INK) | 50 | 50 | 0 | 35.0 |

In Table. 1, all of the solvents remaining after the polymer light-emitting material is removed from the ink was assumed to be 100 parts by weight. The surface tension of each ink was measured by an automatic surface tensiometer (CBVP-Z type, manufactured by Kyowa Interface Science Co., Ltd). The boiling point of xylene is 139°C, the boiling point of anisole is 155°C, and the boiling point of CHB is 240°C, at 1 atm.

A flexographic printing plate made of a polyester resin was used in the flexographic printer. In the used flexographic printing plate, a plurality of convex portions was provided in stripe shapes at a regular interval. The width of each of the convex portions was 35 micrometers, the height of the convex portion was 100 micrometers, and the interval of neighboring convex portions was 188.5 micrometers.

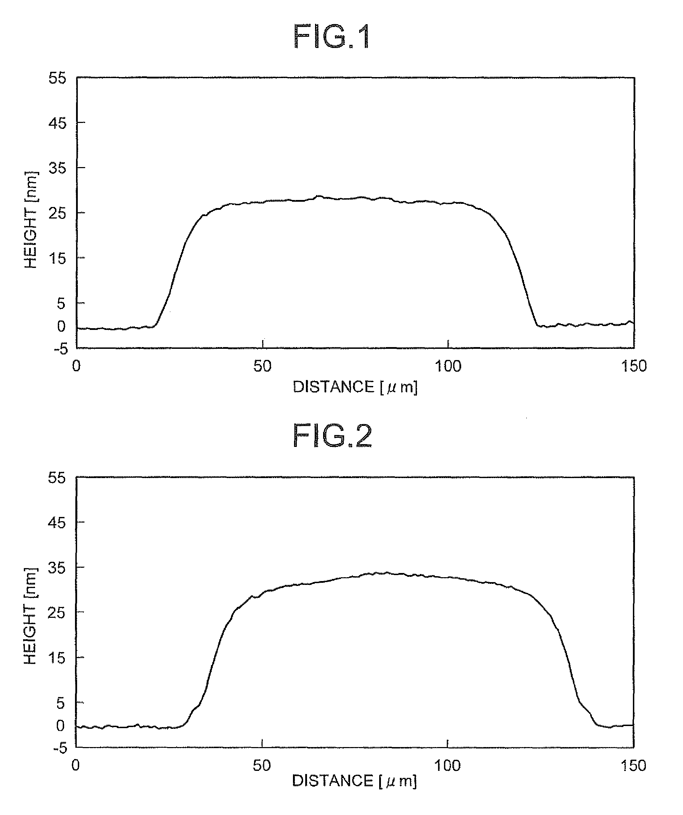

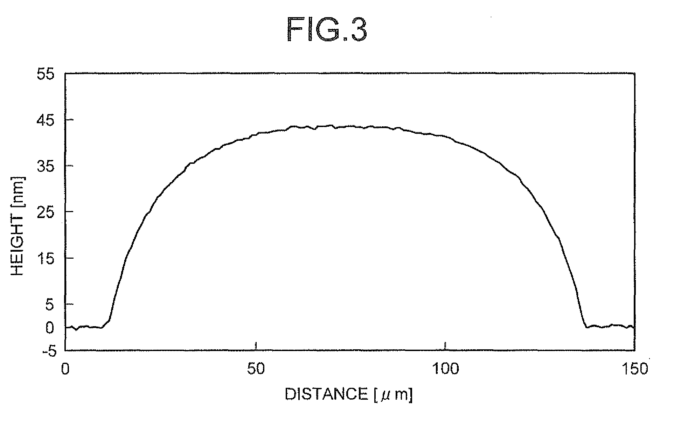

Each ink was printed on the glass substrate by a flexographic printer comprising such a flexographic printing plate and then was dried to form an organic layer in stripe shapes on the glass substrate. FIG. 1 indicates the cross-sectional shape of the organic layer formed using the first ink of Example 1 in Table 1. FIG. 2 indicates the cross-sectional shape of the organic layer formed using the second ink of Example 2 in Table 1. FIG. 3 indicates the cross-sectional shape of the organic layer formed using the third ink of Comparative Example 1 in Table 1. The cross-sectional shape was measured by an optical interferotype microscope (Micromap, manufactured by Ryoka Systems Inc). In FIGS. 1 to 3, the horizontal axis is parallel to the surface of the glass substrate and represents the width (distance) of the organic layer in a direction orthogonal to the longitudinal direction of the layer, and the vertical axis represents a direction vertical to the substrate. Although the width of the convex portion of the letterpress was 35 micrometers, the width of the formed organic layer was about 100 micrometers. This is because, the width of the ink adhering to the letterpress was spread out by pressing the letterpress against the glass substrate serving as an object to be printed.

As indicated in FIGS. 1 and 2, organic layers whose cross-sectional shapes were approximately rectangular shapes and that had uniform film thicknesses were able to be formed by using the inks that comprised the first solvent having a boiling point of equal to or higher than 220°C and that had a surface tension of less than 34 mN/m. In contrast, when an organic layer was formed using the ink having a surface tension of 34 mN/m or more as indicated in FIG. 3, an organic layer whose cross-sectional shape was a dome shape and that had uneven film thickness was formed due to the surface tension.

## Claims

1. An ink for forming an organic layer of an organic electroluminescent element by a printing method, the ink comprising:
a first solvent having a boiling point of equal to or higher than 220°C; and
a constituent material of the organic layer, wherein the ink has a surface tension of less than 34 mN/m.

2. The ink according to claim 1, wherein the amount of the first solvent per 100 parts by weight of the ink is equal to or more than 5 parts by weight and less than 40 parts by weight.

3. The ink according to claim 1, further comprising a second solvent having a boiling point of equal to or higher than 150°C and lower than 220°C.

4. The ink according to claim 3, wherein the amount of the second solvent per 100 parts by weight of the ink is equal to or more than 20 parts by weight and less than 70 parts by weight.

5. The ink according to claim 1, further comprising a third solvent having a boiling point of lower than 150°C.

6. The ink according to claim 3, further comprising a third solvent having a boiling point of lower than 150°C.

7. The ink according to claim 5, wherein the amount of the third solvent per 100 parts by weight of the ink is equal to or more than 20 parts by weight and less than 70 parts by weight.

8. A method for manufacturing an organic electroluminescent element comprising:
preparing an ink that comprises a first solvent having a boiling point of equal to or higher than 220°C and an organic material and that has a surface tension of less than 34 mN/m; and
forming an organic layer by applying the ink by a printing method.

9. The method for manufacturing an organic electroluminescent element according to claim 8, wherein the amount of the first solvent per 100 parts by weight of the ink is equal to or more than 5 parts by weight and less than 40 parts by weight.

10. The method for manufacturing an organic electroluminescent element according to claim 8, wherein the ink further comprises a second solvent having a boiling point of equal to or higher than 150°C and lower than 220°C.

11. The method for manufacturing an organic electroluminescent element according to claim 10, wherein the amount of the second solvent per 100 parts by weight of the ink is equal to or more than 20 parts by weight and less than 70 parts by weight.

12. The method for manufacturing an organic electroluminescent element according to claim 8, wherein the ink further comprises a third solvent having a boiling point of lower than 150°C.

13. The method for manufacturing an organic electroluminescent element according to claim 12, wherein the amount of the third solvent per 100 parts by weight of the ink is equal to or more than 20 parts by weight and less than 70 parts by weight.

14. A display device comprising an organic electroluminescent element manufactured by the method for manufacturing an organic electroluminescent element according to claim 8.
